# FASCICULE DE BREVET EUROPEEN

(11) **EP 3 824 273 B1**
(45) Date de publication et mention de la délivrance du brevet: **24.08.2022**
(21) Numéro de dépôt: 19736383.1
(22) Date de dépôt: 08.07.2019
(51) Int. Cl.: G01N 21/59, C30B 23/00, G01J 3/42

(54) **DISPOSITIF DE MESURE D'UN FLUX DE MATIERE PAR ABSORPTION DE LUMIERE, ET PROCEDE DE MESURE CORRESPONDANT**
VORRICHTUNG ZUR MESSUNG EINES MATERIALFLUSSES DURCH ABSORPTION VON LICHT UND ENTSPRECHENDES MESSVERFAHREN
DEVICE FOR MEASURING A FLUX OF MATTER BY ABSORPTION OF LIGHT, AND CORRESPONDING MEASURING METHOD

(30) Priorité: 20.07.2018 FR 1856743
(43) Date de publication de la demande: 26.05.2021
(73) Titulaire: Centre National de la Recherche Scientifique, 75016 Paris Cedex 16 (FR)
(72) Inventeur: ARNOULT, Alexandre, 31320 AUZEVILLE-TOLOSANE (FR)
(74) Mandataire: Vidon Brevets & Stratégie
(86) Numéro de dépôt international: PCT/EP2019/068286
(87) Numéro de publication internationale: WO 2020/016043

(56) Documents cités:
- WO-A1-2018/078384
- US-A1- 2012 161 022
- Y. DU ET AL: "Self-corrected sensors based on atomic absorption spectroscopy for atom flux measurements in molecular beam epitaxy", APPLIED PHYSICS LETTERS, vol. 104, no. 16, 21 avril 2014 (2014-04-21), page 163110, XP055549072, US ISSN: 0003-6951, DOI: 10.1063/1.4873544

## Description

### 1. DOMAINE DE L'INVENTION

Le domaine de l'invention est celui de la mesure et de contrôle de flux de matière, tel qu'un flux d'atomes ou de molécules par exemple.

Plus précisément, l'invention concerne un dispositif de mesure d'un flux de matière par absorption de lumière par ce flux de matière.

L'invention s'applique notamment, mais non exclusivement, à la technique d'épitaxie par jets moléculaires, aussi appelée technique MBE (pour *« Molecular Beam Epitaxy* ») pour déterminer l'amplitude de flux de matière généré dans une enceinte de dépôt, en vue de contrôler la vitesse de dépôt.

Plus généralement, l'invention peut s'appliquer dans tous les cas où une mesure spectrale par absorption de lumière par un flux de matière est réalisable.

### 2. ARRIÈRE-PLAN TECHNOLOGIQUE

On s'attache plus particulièrement dans la suite de ce document à décrire la problématique existant dans le domaine de l'épitaxie par jets moléculaires, à laquelle a été confronté l'inventeur. L'invention ne se limite bien sûr pas à ce domaine particulier d'application, mais présente un intérêt pour toute technique de mesure de flux de matière devant faire face à une problématique proche ou similaire.

L'épitaxie par jets moléculaires (MBE) est une technique consistant à produire un ou plusieurs flux de matière (flux d'atomes et/ou de molécules) en direction d'un substrat préalablement choisi, tel qu'un wafer d'Arséniure de Gallium par exemple, pour réaliser une croissance épitaxiale de couches minces à base d'un ou plusieurs éléments chimiques d'intérêt (typiquement Aluminium, Gallium, Arsenic, etc.). Cette technique permet de faire croître de manière contrôlée un ensemble de couches minces sur le substrat, typiquement à une vitesse d'une couche atomique par seconde.

Un bâti d'épitaxie par jets moléculaires comprend généralement une enceinte de dépôt sous vide dans laquelle sont émis des flux d'atomes à partir d'une ou plusieurs sources de flux d'atomes (typiquement des cellules à effusion), chaque source de flux étant dirigée vers le substrat de manière à ce que les flux d'atomes émis se condensent uniformément sur celui-ci.

Afin de contrôler la croissance des couches minces sur le substrat, un contrôle du flux d'atomes s'évaporant des cellules à effusion est nécessaire. Pour ce faire, le bâti d'épitaxie dispose, pour chaque cellule à effusion, d'un obturateur mécanique pouvant prendre deux positions : une position fermée dans laquelle il obture le flux d'atomes issu de la cellule à effusion et une position ouverte dans laquelle il laisse passer le flux d'atomes issu de la cellule à effusion.

Toutefois, l'ouverture des obturateurs crée, de manière transitoire et incontrôlée, un excédent de flux de matière d'amplitude inconnue. Ce phénomène transitoire constitue une cause de fluctuation du flux de matière au cours du dépôt.

La spectroscopie offre actuellement, notamment dans la recherche académique, la possibilité d'effectuer des mesures non-destructives et en temps réel pour estimer l'épaisseur des couches minces déposées sur le substrat, et donc contrôler la croissance de l'empilement de couches minces réalisé. Ces mesures non-destructives sont basées sur une analyse spectroscopique de l'absorption de lumière par les atomes présents dans le flux de matière évaporé dans l'enceinte sous vide pendant le dépôt. Cette analyse repose sur la loi de Beer-Lambert qui établit un lien de proportionnalité entre le taux d'absorption d'un faisceau de lumière de longueur d'onde connue traversant le flux de matière, la densité d'atomes de ce flux de matière, ainsi que l'épaisseur de flux de matière traversé. Cette dernière grandeur étant relativement stable au cours du temps, on considère fréquemment que le taux d'absorption dépend principalement de la densité de matière contenue dans le flux.

Une solution connue de mesure de flux de matière consiste à utiliser un dispositif de mesure par spectroscopie d'absorption (aussi appelé spectrophotomètre), lequel repose sur un montage en transmission et la génération d'un faisceau de lumière de mesure dont la longueur d'onde correspond à la longueur d'onde d'absorption de l'élément d'intérêt. Généralement, la longueur d'onde du faisceau de mesure est choisie pour correspondre à la longueur d'onde à laquelle l'absorption de lumière par la matière est maximale. Pour ce faire, le dispositif comprend, pour un élément d'intérêt du flux de matière à mesurer (par exemple le Galium), une lampe à cathode creuse à base dudit élément. Le dispositif de mesure comprend en outre un capteur de lumière monodimensionnel (capteur ayant une dimension de mesure) sensible à une bande spectrale prédéterminée et adapté à l'analyse spectrale. La lampe à cathode creuse, le bâti d'épitaxie et le capteur de lumière sont disposés pour permettre une analyse par transmission de lumière à travers le flux de matière à observer.

Or, l'intensité lumineuse émise par une lampe à cathode creuse fluctue de manière non-négligeable au cours du temps (un dépôt par épitaxie peut durer plusieurs heures), rendant les mesures spectrales imprécises. Ce phénomène constitue une autre cause d'instabilité des mesures au cours du dépôt.

Afin de prendre en compte cette instabilité d'intensité lumineuse des lampes à cathode creuse, une solution pourrait être de disposer d'un capteur bidimensionnel (capteur ayant deux dimensions de mesure). Cette solution comprendrait la génération d'un double faisceau : un premier faisceau - dit de mesure - qui traverserait le flux de matière contenu dans l'enceinte de dépôt et un second faisceau - dit de référence - qui ne passerait pas par le flux de matière et arriverait directement sur le capteur de lumière. Chacun des faisceaux de mesure et de référence serait ensuite détecté à l'aide du capteur bidimensionnel de façon à mesurer indépendamment l'intensité lumineuse de chaque faisceau et de produire le spectre de transmission correspondant au flux de matière analysé. Cette solution est divulguée dans la publication Y. DU ET AL: "Self-corrected sensors based on atomic absorption spectroscopy for atom flux measurements in molecular beam epitaxy", APPLIED PHYSICS LETTERS, vol. 104, no. 16, 21 avril 2014, page 163110.

Cette solution est relativement coûteuse à mettre en œuvre puisqu'elle nécessiterait l'utilisation d'un capteur bidimensionnel dans le dispositif de mesure (spectrophomètre), et donc l'utilisation d'un spectrophotomètre bien plus onéreux.

Afin de s'affranchir d'un capteur bidimensionnel onéreux, une solution pourrait consister à équiper le dispositif de mesure de deux capteurs de lumière monodimensionnels, le premier capteur étant dédié à la mesure d'intensité lumineuse du faisceau de mesure, le deuxième capteur étant dédié à la mesure d'intensité lumineuse du faisceau de référence. Une mesure de flux de matière pourrait alors être effectuée indépendamment des fluctuations d'intensité des lampes à cathode creuse, en prenant en compte les faisceaux de mesure et de référence reçus respectivement par les premier et deuxième capteurs. Afin de prendre en compte les éventuelles dérives de mesure liées à la variation de température des deux capteurs, une source lumineuse supplémentaire de référence serait nécessaire afin de normaliser en continu les sensibilités des deux capteurs de lumière. Cette solution est indiquée dans le document US 2012/161022 A1.

Mais là encore, une telle configuration serait particulièrement coûteuse à mettre en œuvre puisqu'elle nécessiterait l'utilisation de deux capteurs de lumière (par exemple deux spectrophomètres).

Le document WO 2018/078384 A1 divulgue l'utilisation d'un seul détecteur en combinaison avec un commutateur permettant d'envoyer alternativement un faisceau de mesure et un faisceau de référence.

Il apparaîtrait donc particulièrement intéressant de pouvoir disposer d'une technique de mesure de flux de matière qui intégrerait un seul capteur monodimensionnel tout en permettant une mesure simultanée d'un signal de mesure et d'un

### signal de référence.

### 3. EXPOSÉ DE L'INVENTION

Dans un mode de réalisation particulier de l'invention, il est proposé un dispositif de mesure d'un flux de matière, comprenant :
- au moins une première source lumineuse source lumineuse configurée pour émettre un premier faisceau de lumière ayant une longueur d'onde de mesure correspondant à la longueur d'onde d'absorption d'un élément d'intérêt dudit flux de matière ;
- un connecteur optique ;
- un capteur de lumière configuré pour recevoir, via ledit connecteur optique :
   ∘ un faisceau atténué résultant d'une transmission du premier faisceau de lumière à travers ledit flux de matière ;
   ∘ un faisceau non-atténué résultant d'une transmission du premier faisceau de lumière sans passer par ledit flux de matière.

Le dispositif est tel que le capteur de lumière est un capteur de lumière monodimensionnel et que le connecteur optique est positionné par rapport au capteur de lumière monodimensionnel pour que le centre du connecteur optique soit aligné avec le centre du capteur de lumière monodimensionnel, de telle sorte que le faisceau non-atténué soit spectralement dirigé vers une première partie du capteur de lumière monodimensionnel et que le faisceau atténué est spectralement dirigé vers une deuxième partie du capteur de lumière monodimensionnel.

Ainsi, ce mode de réalisation particulier de l'invention offre une solution simple et innovante consistant à créer volontairement un désalignement du connecteur optique recevant les faisceaux de lumière atténué et non-atténué, par rapport à l'entrée d'un capteur de lumière monodimensionnel, de façon à permettre la mesure simultanée de ces faisceaux de lumière avec une seule dimension de mesure.

Ainsi, cette solution offre la possibilité d'utiliser un capteur monodimensionnel peu coûteux pour réaliser une mesure de flux de matière insensible à l'instabilité de la source lumineuse.

Selon un aspect particulier de l'invention, le capteur de lumière monodimensionnel et le connecteur optique sont définis respectivement selon un axe longitudinal et un axe d'alignement, de sorte que l'axe longitudinal du capteur et l'axe d'alignement du connecteur forment un angle strictement supérieur à 0° et strictement inférieur à 180°.

Plus précisément, l'angle formé entre l'axe d'alignement et l'axe longitudinal du capteur est compris entre 85° et 95°. Ainsi, cet angle reste suffisamment proche de 90° pour assurer un décalage spectral suffisant des représentations spectrales résultant des faisceaux atténué et non-atténué.

Ainsi, en disposant d'un tel agencement, l'inventeur a observé que le signal spectral obtenu sur une dimension de mesure correspondait à une combinaison d'un signal atténué (résultant du faisceau atténué) et d'un signal de référence (résultant du faisceau non-atténué), chacun décalé spectralement de part et d'autre de la longueur d'onde de mesure. Ceci est d'autant plus astucieux que, pour l'Homme du Métier, le fait de désaligner le connecteur optique par rapport au capteur aurait dû décroitre l'intensité lumineuse détecté et donc dégrader le signal de mesure, au point qu'une telle approche n'aurait pas été adoptée par celui-ci. Il a été observé en effet que malgré une dégradation du signal optique, il était possible d'effectuer dans des conditions suffisantes une mesure du flux de matière, restant insensible aux fluctuations de la source lumineuse.

Selon un autre aspect particulier de l'invention, le capteur de lumière monodimensionnel est positionné à l'horizontal et dans lequel la première partie est une partie droite du capteur de lumière monodimensionnel et la deuxième partie est une partie gauche du capteur de lumière monodimensionnel.

On peut assimiler les parties droite et gauche du capteur à des premier et deuxième photosites ou des premier et deuxième groupements de photosites du capteur. Les premier et deuxième photosites ou groupements de photosites peuvent être ou non adjacents.

Selon un aspect particulier de l'invention, le dispositif comprend un élément séparateur de faisceau configuré pour séparer le premier faisceau de lumière sur la base d'un rapport de séparation d'intensité lumineuse défini par *a*/*b,* avec *a* compris entre 50 et 70 et *b* compris entre 50 et 30.

Selon un aspect particulier de l'invention, ladite au moins une première source lumineuse est une lampe à cathode creuse, ledit dispositif comprenant une deuxième source lumineuse configurée pour émettre un deuxième faisceau de lumière spectralement stable et ayant une longueur d'onde différente de ladite longueur d'onde d'absorption, ledit deuxième faisceau étant émis vers le capteur de lumière monodimensionnel en empruntant un chemin optique emprunté par le faisceau atténué.

L'utilisation d'une diode électroluminescente par exemple comme deuxième source lumineuse permet de prendre en compte les dérives de mesure liées à la variation du trajet optique de mesure.

Selon un aspect particulier de l'invention, les faisceaux atténué et non-atténué reçus par le capteur de lumière monodimensionnel se présentent sous la forme d'un signal spectral combiné représentatif d'une combinaison d'un signal spectral de mesure correspondant au faisceau atténué reçu et d'un signal spectral de référence correspondant au faisceau non-atténué reçu.

Selon un aspect particulier de l'invention, le dispositif comprend un moyen optiquement réfléchissant configuré pour réfléchir le faisceau atténué vers ledit flux de matière pour produire un faisceau doublement atténué résultant d'une transmission double du premier faisceau de lumière à travers ledit flux de matière, le capteur de lumière monodimensionnel étant configuré pour recevoir et diriger ledit faisceau doublement atténué vers la deuxième partie du capteur de lumière monodimensionnel.

Une telle configuration permet de d'augmenter la précision des mesures de flux de matière.

Dans un autre mode de réalisation de l'invention, il est proposé un procédé de mesure d'un flux de matière au moyen du dispositif de mesure précité (selon l'un quelconque de ses différents modes de réalisation), le procédé comprenant une étape de mesure du flux de matière en fonction du faisceau atténué reçu par la première partie du capteur de lumière monodimensionnel et du faisceau non-atténué reçu par la deuxième partie du capteur de lumière monodimensionnel.

Dans un autre mode de réalisation de l'invention, il est proposé un produit programme d'ordinateur qui comprend des instructions de code de programme pour la mise en œuvre du procédé précité (dans l'un quelconque de ses différents modes de réalisation), lorsque ledit programme est exécuté sur un ordinateur.

Dans un autre mode de réalisation de l'invention, il est proposé un médium de stockage lisible par ordinateur et non transitoire, stockant un programme d'ordinateur comprenant un jeu d'instructions exécutables par un ordinateur pour mettre en œuvre le procédé précité (dans l'un quelconque de ses différents modes de réalisation).

### 4. LISTE DES FIGURES

D'autres caractéristiques et avantages de l'invention apparaîtront à la lecture de la description suivante, donnée à titre d'exemple indicatif et non limitatif, et des dessins annexés, dans lesquels :
- la figure 1 présente un synoptique d'un dispositif de mesure selon un premier mode de réalisation particulier de l'invention ;
- les figures 2a-2c représentent schématiquement le principe de mesure par absorption d'un flux de matière reposant sur l'utilisation d'un capteur de lumière bidimensionnel ;
- les figures 3a et 3b représentent schématiquement le principe de mesure par absorption d'un flux de matière reposant sur l'utilisation d'un capteur de lumière monodimensionnel ;
- la figure 4 présente un synoptique d'un dispositif de mesure selon un deuxième mode de réalisation particulier de l'invention ;
- la figure 5 présente la structure simplifiée d'une unité de traitement pouvant être compris dans un dispositif de mesure selon un mode de réalisation particulier de l'invention.

### 5. DESCRIPTION DÉTAILLÉE

Sur toutes les figures du présent document, les éléments identiques sont désignés par une même référence numérique.

Le principe de l'invention repose sur une approche astucieuse consistant à créer artificiellement un désalignement du connecteur optique recevant les faisceaux de lumière atténué et non-atténué, par rapport à l'entrée du capteur de lumière monodimensionnel, afin de permettre une mesure simultanée d'un signal de mesure et d'un signal de référence sur un capteur utilisant seulement une dimension de mesure.

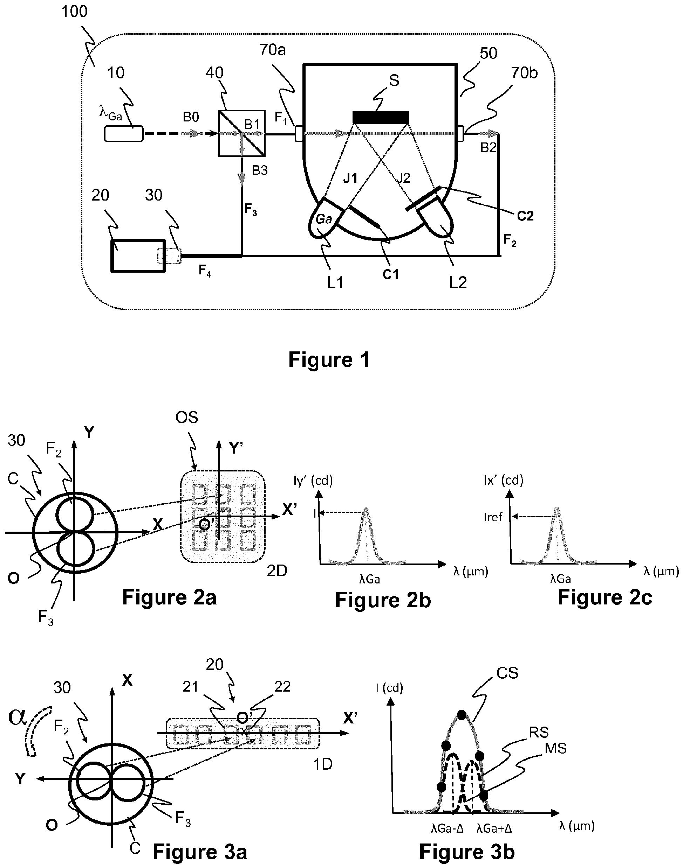

On présente, en relation avec la **figure 1****,** un schéma simplifié d'un dispositif de mesure 100 selon un premier mode de réalisation particulier de l'invention. Dans ce mode de réalisation particulier, le dispositif de mesure 100 permet de délivrer en temps réel, par spectrophotométrie d'absorption atomique, une représentation spectrale d'un flux de matière qui est pulvérisé en direction d'un substrat S selon la technique d'épitaxie par jets moléculaires. L'élément chimique d'intérêt pris ici à titre d'exemple est le Gallium (Ga). Bien entendu, d'autres éléments chimiques d'intérêt ou combinaison d'éléments chimiques d'intérêt peuvent être utilisés sans sortir du cadre de l'invention.

Le dispositif de mesure 100 comprend une source lumineuse 10, un cube séparateur de faisceau 40, un bâti d'épitaxie par jets moléculaires 50, un capteur de lumière monodimensionnel 20, un connecteur optique 30, et une unité de traitement (non représentée sur la figure). Comme illustré sur la figure, les éléments du dispositif 100 sont disposés de façon à permettre une analyse par transmission de lumière à travers le flux de matière à analyser.

Le bâti d'épitaxie 50 comprend une enceinte de dépôt sous vide équipée de deux sources de flux atomiques : une première source L1, de type cellule à effusion, servant à l'effusion d'un jet d'atomes de Gallium (J1) orientée vers le substrat S et une deuxième source L2, de type cellule à effusion, servant à l'effusion d'un jet d'atomes de d'Arsenic (J2) orientée vers le substrat S. La source de flux L1 est associée à un obturateur mécanique C1 et la source de flux L2 avec un obturateur mécanique C2. Pour ne pas surcharger la figure, seules deux sources de flux d'atomes sont représentées sur celle-ci à titre d'exemple purement illustratif. A noter que le nombre et la disposition des sources de flux ne sont pas limités au présent exemple et peuvent être adaptés au cas par cas, en fonction notamment de la nature et du type de dépôt réalisé. Dans la suite de la description, afin de faciliter la compréhension de l'invention, on part du principe que seule la source de flux d'atomes de Gallium (L1) est activée pendant la mesure spectrale. Bien entendu, le principe général de l'invention s'applique aussi bien à une enceinte de dépôt mono-source qu'à une enceinte de dépôt multi-source.

Le principe de mesure mis en œuvre par le dispositif 100 est basé sur la génération d'un double faisceau : un premier faisceau de mesure (ou faisceau atténué) qui traverse le flux de matière J1 et un second faisceau de référence (ou faisceau non-atténué) qui ne passe pas par le flux de matière J1 et arrive directement sur le capteur de lumière monodimensionnel 20.

La source lumineuse 10 est choisie de manière à ce qu'elle émette une longueur d'onde adaptée au flux d'atomes à mesurer, c'est-à-dire donnant lieu à une absorption de photons à cette longueur d'onde par le flux d'atomes J1. Dans le présent exemple, la source lumineuse est donc une lampe à cathode creuse à base de Gallium. Cette lampe présente en effet l'avantage d'émettre un faisceau de lumière ayant une longueur d'onde caractéristique correspondant à la longueur d'onde d'absorption des atomes de Gallium (λ_{Ga} = 417 nm).

Le capteur de lumière 20 selon l'invention est un capteur de lumière monodimensionnel, tel que par exemple un spectromètre de type barrette CCD, sensible à la plage de longueurs d'onde UV (typiquement comprise entre 380 et 457 nm). Il est configuré pour détecter l'intensité de la lumière UV qu'il reçoit via le connecteur optique 30 et la convertit en signal électrique à destination de l'unité de traitement. L'unité de traitement est raccordée électriquement au capteur de lumière 20 d'une part et à la source lumineuse 10 d'autre part, ainsi qu'à l'enceinte de dépôt pour piloter les sources de flux L1 et L2.

D'une manière générale, on entend par « capteur monodimensionnel » dans le cadre de la présente invention, un capteur ayant une dimension de mesure ou un capteur bidimensionnel utilisant une seule dimension de mesure.

L'objet du dispositif de mesure 100 est de mesurer l'amplitude du flux de matière J1 émis par la source de flux L1, afin de contrôler la vitesse de dépôt des atomes de Gallium sur le substrat S. Pour cela, la source lumineuse 10 émet un faisceau de lumière incident B0 de longueur d'onde λ_{Ga} en direction du cube séparateur de faisceau 40. Le cube séparateur de faisceau 40 est utilisé ici pour dédoubler le faisceau de lumière incident sur la base d'un rapport de séparation d'intensité lumineuse 70/30. Ainsi, le cube séparateur 40 est agencé de façon à diviser le faisceau de lumière incident B0 en un premier faisceau transmis B1, de longueur d'onde λ_{Ga}, et un second faisceau réfléchi B2, de même longueur d'onde λ_{Ga}, sur base du rapport de séparation précité (70% pour le faisceau B1 et 30% pour faisceau B2). Le faisceau transmis B1 est envoyé vers l'enceinte de dépôt du bâti d'épitaxie 50 au moyen d'un guide optique, tel qu'une fibre optique multimode F₁, afin d'être acheminé vers la fenêtre d'entrée de l'enceinte de dépôt. Un élément ou un système de focalisation et/ou de collimation optique 70a est couplé à la fibre optique F₁ d'une part et à la paroi de l'enceinte de dépôt d'autre part, pour que le faisceau transmis B1 puisse être correctement injecté dans l'enceinte de dépôt de sorte qu'il soit absorbé par le flux d'atomes J1 dans les meilleures conditions possibles. Le faisceau lumineux B1 ensuite traverse le flux d'atomes J1 jusqu'à la fenêtre de sortie de l'enceinte de dépôt. Une partie de la lumière du faisceau lumineux est alors absorbée selon le phénomène d'absorption atomique décrit plus haut, l'autre partie étant transmise. Un élément ou un système de défocalisation ou de décollimation optique 70b est en outre couplé, d'une part à la fenêtre de sortie et à la fibre optique F₂ d'autre part, afin que le faisceau lumineux B2 sortant de l'enceinte de dépôt puisse être correctement injecté dans la fibre optique F₂ avant d'atteindre le capteur de lumière monodimensionnel 20. Quant au faisceau réfléchi B3 sortant du cube séparateur 40, celui-ci est directement injecté dans une autre fibre optique multimode F₃ sans passer par le bâti d'épitaxie 50.

Le faisceau lumineux B2, issu du bâti d'épitaxie 50, est par la suite appelé « faisceau atténué » ou « faisceau de mesure », du fait qu'il résulte d'une transmission du faisceau de lumière incident B0 à travers le flux d'atomes J1.

Le faisceau de lumière B3 issu du cube séparateur 40 est par la suite appelé « faisceau non-atténué » ou « faisceau de référence », du fait qu'il résulte d'une transmission du faisceau de lumière incident B0 sans passer par le flux d'atomes J1.

Les fibres optiques F₂ et F₃ sont regroupées en un guide optique multi-cœur F₄. Ce guide optique F₄ transporte ainsi le faisceau atténué B2 et le faisceau non-atténué B3 jusqu'au connecteur optique 30.

Le connecteur optique 30 (par exemple un connecteur de type SMA) est un connecteur d'extrémité de fibres optiques disposé à l'extrémité libre du guide optique F₄. Sa fonction est d'aligner et de coupler mécaniquement les fibres optiques au capteur de lumière 20 afin que la lumière issue des fibres optiques F₂ et F₃ puisse être transmise au capteur de lumière 20 à travers la fente d'entrée de celui-ci. Un tel connecteur est aussi parfois appelé ferrule embout, ou coupleur optique.

On présente maintenant, en relation avec la **figure 2a****,** un exemple de configuration entre un connecteur optique 30 et un capteur de lumière bidimensionnel OS telle qu'existante dans l'art antérieur. Le connecteur optique 30, vue en coupe, est représenté ici dans un système de référence (O ; X, Y). Le connecteur optique 30 comprend un corps C de section circulaire et de centre O qui s'étend le long des axes transversaux X et Y. Le corps C a un diamètre compris typiquement entre 2 et 10 mm et comprend, pour chaque fibre du guide optique F₄, une ouverture pour recevoir ladite fibre au niveau de son extrémité.

Dans cette configuration, la fibre optique F₂ (qui transporte le faisceau de mesure) est superposée à la fibre optique F₃ (qui transporte le faisceau de référence) selon l'axe transversal Y du corps C (on parle alors d'alignement vertical). Autrement dit, les fibres optiques F₂ et F₃ sont alignées à l'entrée du capteur de lumière OS selon l'axe transversal Y du corps C, dit « axe d'alignement des fibres ». Ainsi, on entend par « aligner les fibres optiques », le fait d'agencer le connecteur optique pour que le centre O du connecteur optique soit aligné avec le centre O' du capteur de lumière OS et de sorte que l'axe transversal Y des fibres optiques F₂ et F₃ soit confondu avec l'axe longitudinal Y' du capteur de lumière (cet axe Y' correspond en fait à l'axe longitudinal de la fente d'entrée du capteur). Or, pour visualiser simultanément le signal spectral de mesure (**figure 2b**) et le signal spectral de référence (**figure 2c**), il est nécessaire d'utiliser un capteur de lumière bidimensionnel OS, c'est-à-dire un capteur ayant deux dimensions de mesure. Celui-ci est représenté sur la figure 2a dans un système de référence bidimensionnel (O' ; X', Y'). En effet, lorsque les fibres optiques F₂ et F₃ sont verticalement alignées à l'entrée du capteur de lumière OS (l'axe d'alignement Y du connecteur étant alors confondu avec l'axe Y' du capteur), l'image résultante obtenue par le capteur bidimensionnel OS est spatialement résolue et présente deux représentations spectrales distinctes, comme illustrées sur les figures 2b et 2c. Le symbole « *I* » représente l'intensité lumineuse du faisceau de mesure détectée sur une première dimension de mesure (correspondant à l'axe Y' du capteur OS, « *Iy'* » représentant l'intensité lumineuse détectée selon ledit axe Y') et le symbole *« Iref »* représente l'intensité lumineuse du faisceau de référence détectée sur une deuxième dimension de mesure (correspondant à l'axe X' du capteur OS, « *Ix' »* représentant l'intensité lumineuse détectée selon ledit axe X'). Comme on peut le voir, pour obtenir la représentation spectrale des faisceaux de mesure B2 et de référence B3, le capteur OS détecte simultanément et de manière indépendante l'intensité lumineuse du faisceau de référence sur l'axe OX' (première dimension de mesure) et d'autre part l'intensité lumineuse du faisceau de mesure sur l'axe OY' (deuxième dimension de mesure). Comme discuté plus haut en relation avec l'art antérieur, cette solution présente l'inconvénient d'être coûteuse à mettre en œuvre, et l'utilisation d'un capteur monodimensionnel pourrait présenter une solution particulièrement avantageuse, notamment dans le cadre de la recherche académique.

La **figure 3a** représente schématiquement un exemple de configuration du connecteur optique 30 et du capteur monodimensionnel 20 conforme à l'invention.

Le capteur de lumière monodimensionnel 20 est représenté ici dans un système de référence monodimensionnel (O' ; X'). Dans cette configuration, le capteur est dit être positionné à l'horizontal.

L'idée consiste à positionner le connecteur optique 30 par rapport au capteur de lumière monodimensionnel 20 pour que le centre O du connecteur optique 30 soit aligné avec le centre O' du capteur monodimensionnel 20, et de telle sorte que le faisceau de mesure B2 de la fibre F₂ soit spectralement dirigé vers une première partie 21 (dite « partie gauche ») du capteur monodimensionnel 20 et que le faisceau de référence B3 de la fibre F₃ soit spectralement dirigé vers une deuxième partie 22 (dite « partie droite ») du capteur monodimensionnel 20.

Plus précisément dans cet exemple particulier, le capteur de lumière monodimensionnel 20 et le connecteur optique 30 sont disposés l'un par rapport à l'autre de sorte que l'axe longitudinal X' du capteur monodimensionnel 20 et l'axe transversal Y du connecteur optique 30 forment un angle α sensiblement égal à 90°. De cette manière, l'axe d'alignement Y (i.e. l'axe passant par les fibres optiques F₂ et F₃ se trouve confondu avec l'axe longitudinal X' du capteur monodimensionnel 20, afin de générer volontairement, côté réception, un décalage en longueur d'onde des deux faisceaux. Ce décalage en longueur est noté Δ sur le spectre de transmission illustré à la **figure 3b****.** Ainsi, lorsque les fibres optiques F₂ et F₃ sont horizontalement alignées à l'entrée du capteur de lumière monodimensionnel 20 (l'axe d'alignement Y étant alors confondu avec l'axe X' du capteur), l'image résultante obtenue par le capteur présente une seule représentation spectrale distincte (CS).

Cette configuration est particulièrement avantageuse puisqu'elle offre la possibilité d'utiliser un capteur de lumière à une dimension de mesure, qui présente l'avantage d'être moins coûteux qu'un capteur de lumière bidimensionnel, tout en permettant une mesure simultanée du faisceau de mesure B2 et du faisceau de référence B3.

Il s'agit ici d'un mode de réalisation particulier dans lequel le décalage en longueur d'onde des faisceaux est maximal. Mais on peut tout à fait envisager d'autres configurations répondant au principe général suivant : le capteur de lumière 20 est disposé par rapport au connecteur optique 30 tel que l'axe longitudinal X' du capteur 20 et l'axe d'alignement Y du connecteur 30 forment un angle de désalignement α compris strictement entre 0° et 180°. En d'autres termes, selon le principe général de l'invention, l'axe d'alignement Y du connecteur optique 30 n'est plus aligné sur l'entrée du capteur de lumière 20. De cette manière, il est possible d'effectuer une mesure simultanée du faisceau de référence B3 et du faisceau de mesure B2 avec une seule dimension de mesure, dans la mesure où le faisceau de référence B3 et le faisceau de mesure B2 sont spectralement dirigés, respectivement vers une première et deuxième zones distinctes du capteur de lumière monodimensionnel 20.

Par « zone » ou « partie » du capteur de lumière, on entend un photosite ou un groupement de photosites du capteur. Dans un exemple de réalisation particulier, le connecteur optique 30 et le capteur de lumière monodimensionnel 20 sont configurés de sorte que lesdites première et deuxième zones du capteur de lumière monodimensionnel correspondent, respectivement, à des premier et deuxième photosites ou des premier et deuxième groupes de photosites.

S'approcher d'un angle de 90° est néanmoins intéressant dans la mesure où cette configuration assure un décalage maximal en longueur d'onde, ce qui permet une mesure plus précise du flux d'atomes J1. Plus précisément, l'angle formé entre l'axe d'alignement et l'axe longitudinal du capteur peut être compris entre 85° et 95°. Ainsi, cet angle reste suffisamment proche de 90° pour assurer un décalage spectral suffisant des signaux résultant des faisceaux atténué et non-atténué.

La courbe référencée CS sur la figure 3b représente le signal spectral généré par le capteur de lumière monodimensionnel 20. Il s'agit en fait d'un signal spectral combiné représentatif d'une combinaison d'un signal spectral de mesure (raie référencée MS) correspondant au faisceau de mesure B2 reçu et d'un signal spectral de référence (raie référencée RS) correspondant au faisceau de référence B3 reçu. On s'aperçoit que le désalignement des deux fibres optiques d'un angle α par rapport l'entrée du capteur de lumière 20 induit un décalage en longueur d'onde (Δ) de part et d'autre de la longueur d'onde d'absorption du Gallium. A partir de ce signal spectral combiné CS, il est alors possible pour l'unité de traitement de déduire l'amplitude du flux d'atomes J1 en cours d'évaporation dans l'enceinte de dépôt 50, tout en tenant compte de la dérive de mesure liée à l'instabilité d'intensité lumineuse de la lampe à cathode creuse L1. Dans l'exemple illustré ici, l'unité de traitement se base sur cinq points de mesure de la courbe CS (représentés par les points noirs) pour mesurer l'intensité lumineuse de chaque faisceau. Cette disposition permet ainsi de s'affranchir de toute dérive de mesure liée à l'instabilité d'intensité lumineuse de la lampe à cathode creuse L1. Bien entendu, un nombre plus ou moins important de points de mesure peuvent être pris en compte en fonction de la précision souhaitée des mesures.

A noter que l'utilisation d'un spectromètre à plus grande focale (c'est-à-dire supérieure à 101 mm) permettrait de séparer encore plus clairement les signaux de mesure et de référence, et ainsi de faciliter la prise en compte de la dérive de mesure. A titre d'alternative, il est également possible d'effectuer une phase de calibration préalable à la mesure pour discriminer les signaux de mesure et de référence de manière fiable et robuste. Pour ce faire, des signaux de mesure et de référence sont obtenus successivement en obturant les trajets optiques associés aux fibres F₂ et F₃ l'un après l'autre. Cette phase de calibration permet à l'unité de traitement de mesurer les formes des deux raies, et ainsi de déterminer la part relative des deux signaux grâce à la mesure de la courbe CS à aux moins deux longueurs d'onde différentes. Une mesure sur un nombre plus important de points permet de vérifier la validité de la solution trouvée.

Couplé à un système d'asservissement (non représenté), il est tout à fait possible de contrôler l'ouverture et la fermeture de l'obturateur C1 associé à la source de flux L1, de façon à moduler l'amplitude du flux d'atomes s'évaporant de la source, en fonction du résultat de mesure obtenu par l'unité de traitement.

A noter également que le rapport d'intensité lumineuse 70/30 du cube séparateur 40 est donné à titre d'exemple purement illustratif. Le cube séparateur 40 peut très bien être conformé pour diviser le faisceau incident B0 en un faisceau transmis B1 et un faisceau réfléchi B3 de rapport d'intensité lumineuse compris entre 50/50 et 70/30 respectivement.

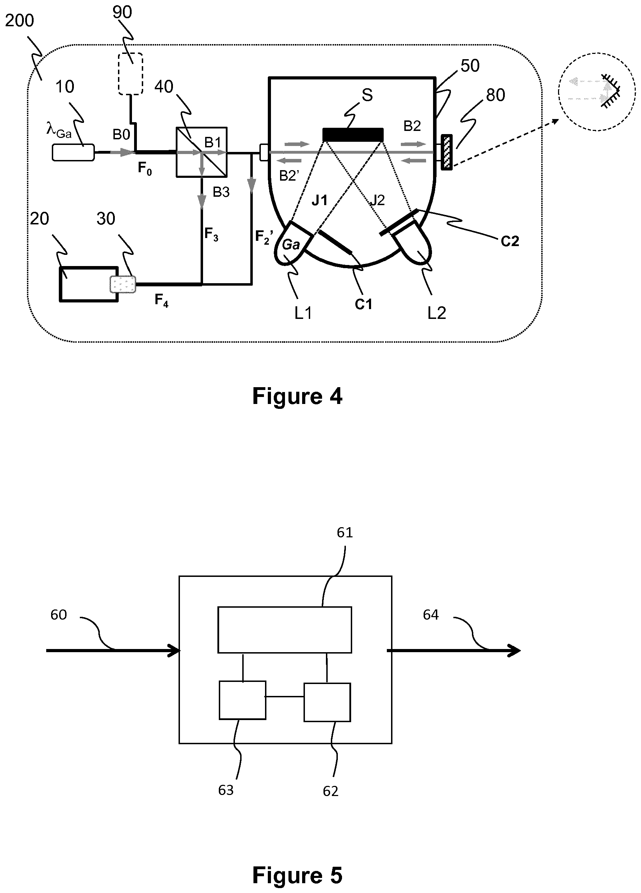

On présente maintenant, en relation avec la **figure 4****,** un dispositif de mesure 200 selon un deuxième mode de réalisation particulier de l'invention.

Par rapport au premier mode de réalisation, le dispositif de mesure 200 propose une configuration optique permettant de réaliser un va-et-vient du faisceau de mesure dans l'enceinte de dépôt. Pour ce faire, le dispositif de mesure 200 comprend un réflecteur optique 80 adapté pour réfléchir le faisceau atténué B2 sortant de l'enceinte de dépôt et le renvoyer à nouveau à travers le flux d'atomes J1, pour produire un faisceau doublement atténué B2' résultant d'une transmission double du faisceau de lumière à travers le flux d'atomes J1. Le faisceau doublement atténué B2' est guidé depuis l'entrée du bâti 50 jusqu'au connecteur optique 30 au moyen de la fibre optique F₂'.

Les fibres optiques F₂' et F₃ sont regroupées dans le guide optique multi-cœur F₄. Ce guide optique F₄ transporte ainsi le faisceau doublement atténué B2' (faisceau de mesure) et le faisceau non-atténué B3 (faisceau de référence) jusqu'au capteur de lumière monodimensionnel 20 via le connecteur optique 30.

Le positionnement du connecteur optique 30 par rapport au capteur de lumière monodimensionnel 20 est identique à celle présentée dans le premier mode de réalisation. Ainsi, le faisceau non-atténué B2 est spectralement dirigé vers la première partie 22 du capteur et que le faisceau doublement atténué B2' est spectralement dirigé vers la deuxième partie 21 du capteur.

Au lieu d'effectuer une mesure du flux de matière en fonction du faisceau atténué B2, l'unité de traitement effectue ici une mesure du flux de matière en fonction du faisceau doublement atténué B2' par le capteur de lumière monodimensionnel. Les mesures spectrales obtenues avec cette configuration particulière sont donc plus précises.

Bien entendu, l'utilisation d'un réflecteur optique est un exemple particulier et il est possible d'utiliser d'autres moyens remplissant la même fonction de réflexion de lumière, tel qu'un miroir optique par exemple.

Selon un aspect particulier, le dispositif de mesure 200 comprend en outre une source lumineuse 90, dite de calibration, dont la longueur d'onde est telle que le rayonnement émis n'est absorbé par aucun des flux d'atomes issus des sources de flux. On peut envisager l'utilisation d'une diode électroluminescente (DEL) par exemple, pour ses propriétés de stabilité spectrale et dont la longueur d'onde λ_{DEL} est différente de celle du faisceau de lumière émis par la cellule à cathode creuse 10, mais détectable par le capteur de lumière 20. On peut utiliser typiquement une diode électroluminescente de longueur d'onde λ_{DEL} = 450 nm. Cette diode 90 est disposée dans le dispositif de mesure 200 de sorte que le faisceau de lumière de calibration emprunte le même chemin optique que le faisceau doublement atténué B2' servant à faire la mesure du signal atténué (depuis la source lumineuse 10 jusqu'au capteur de lumière 20). Ici, la diode 90 est couplée à la fibre optique d'entrée F₀ commune à la source lumineuse 10. Une mesure en continu de ce faisceau de calibration permet d'obtenir un signal de calibration pour la mesure d'intensité lumineuse du faisceau doublement atténué B2' grâce à un filtre optique (non représenté sur la figure) ou un séparateur de faisceau (comme le séparateur de faisceau 40) qui est configuré pour empêcher le faisceau de calibration issu de la diode 90 d'aller dans la fibre optique F₃ (le faisceau de calibration doit effectivement n'emprunter que le bras de mesure et non le bras de référence). Le suivi en continu de l'intensité lumineuse de ce faisceau de calibration, permet à l'unité de traitement de contrôler en continu l'alignement du trajet optique et de prendre en compte toute dérive liée par exemple à la dilation du bâti d'épitaxie 50, en comparant le signal de mesure de flux d'atomes à ce signal de référence. En effet, il est fréquent que le bâti d'épitaxie, soumis à de fortes températures, se dilate, ce qui peut rendre le trajet optique de mesure instable.

Le dispositif de mesure décrit ci-dessus selon l'un quelconque de ses modes de réalisation est adapté à la technique d'épitaxie par jets moléculaires. Il peut s'appliquer à toute autre technique de dépôt ou d'évaporation de matière où une mesure par absorption de lumière est réalisable.

Le dispositif de mesure permet un fonctionnement indépendant des sources de flux L1 et L2 pour la réalisation d'un empilement de couches minces différentes superposées. Le dispositif de mesure permet également un fonctionnement simultané de plusieurs sources et un co-dépôt de plusieurs matériaux. Comme chaque faisceau lumineux de mesure est absorbé par un flux d'atomes particulier, il est donc possible de mesurer l'amplitude des flux d'atomes émis simultanément.

Les sources de flux d'atomes L1-L2 étant équipées d'obturateurs individuels C1-C2, il est possible de déposer successivement ou simultanément plusieurs matériaux tout en modulant l'amplitude du flux d'atomes J1-J2 issu de chaque source d'atomes L1-L2.

La **figure 5** présente la structure simplifiée d'une unité de traitement mettant en œuvre un procédé de mesure selon un mode de réalisation particulier de l'invention. Sur initialisation du procédé, l'unité de traitement effectue une étape de mesure du flux de matière en fonction du faisceau atténué reçu par la première partie du capteur de lumière monodimensionnel et du faisceau non-atténué reçus par la deuxième partie du capteur de lumière monodimensionnel.

Cette unité de traitement comprend une mémoire vive 63 (par exemple une mémoire RAM), un module de traitement 61, équipée par exemple d'un processeur, et pilotée par un programme d'ordinateur stocké dans une mémoire morte 62 (par exemple une mémoire ROM ou un disque dur). A l'initialisation, les instructions de code du programme d'ordinateur sont par exemple chargées dans la mémoire vive 63 avant d'être exécutées par le processeur du module de traitement 61. Le module de traitement 61 reçoit en entrée un signal spectral combiné 60 obtenu à partir du faisceau atténué et du faisceau non-atténué détecté par le capteur de lumière monodimensionnel 20 sur deux zones distinctes de celui-ci. Le processeur du module de traitement 61 traite le signal spectral combiné 60 et génère en sortie une information temps réel 64 relative à l'amplitude du flux de matière mesuré à un instant t, selon les instructions du programme 62.

Cette figure 5 illustre seulement une manière particulière, parmi plusieurs possibles, de réaliser une mesure de flux de matière. En effet, la technique de l'invention se réalise indifféremment :
- sur une machine de calcul reprogrammable (un ordinateur PC, un processeur DSP ou un microcontrôleur) exécutant un programme comprenant une séquence d'instructions, ou
- sur une machine de calcul dédiée (par exemple un ensemble de portes logiques comme un FPGA ou un ASIC, ou tout autre module matériel).

Dans le cas où l'invention est implantée sur une machine de calcul reprogrammable, le programme correspondant (c'est-à-dire la séquence d'instructions) pourra être stocké dans un médium de stockage amovible (tel que par exemple une disquette, un CD-ROM ou un DVD-ROM) ou non, ce médium de stockage étant lisible partiellement ou totalement par un ordinateur ou un processeur.

## Revendications

1. Dispositif de mesure (100) d'un flux de matière, comprenant :
- au moins une première source lumineuse (10) configurée pour émettre un premier faisceau de lumière ayant une longueur d'onde correspondant à la longueur d'onde d'absorption d'un élément d'intérêt dudit flux de matière ;
- un connecteur optique (30) ;
- un capteur de lumière (20) configuré pour recevoir, via ledit connecteur optique :
∘ un faisceau atténué résultant d'une transmission du premier faisceau de lumière à travers ledit flux de matière ;
∘ un faisceau non-atténué résultant d'une transmission du premier faisceau de lumière sans passer par ledit flux de matière ; et
le dispositif étant **caractérisé en ce que** le capteur de lumière est un capteur de lumière monodimensionnel ;
et **en ce que** le connecteur optique est positionné par rapport au capteur de lumière monodimensionnel pour que le centre du connecteur optique est aligné avec le centre du capteur de lumière monodimensionnel, de telle sorte que le faisceau non-atténué est spectralement dirigé vers une première partie du capteur de lumière monodimensionnel et que le faisceau atténué est spectralement dirigé vers une deuxième partie du capteur de lumière monodimensionnel.

2. Dispositif selon la revendication 1, dans lequel le capteur de lumière monodimensionnel et le connecteur optique sont définis respectivement selon un axe longitudinal (X) et un axe d'alignement (Y), de sorte que l'axe longitudinal (X') du capteur et l'axe d'alignement (Y) du connecteur forment un angle (a) strictement supérieur à 0° et strictement inférieur à 180°.

3. Dispositif selon la revendication 1, dans lequel le capteur de lumière monodimensionnel est positionné à l'horizontal (X') et dans lequel la première partie est une partie droite (21) du capteur de lumière monodimensionnel et la deuxième partie est une partie gauche (22) du capteur de lumière monodimensionnel.

4. Dispositif selon l'une quelconque des revendications 1 à 3, comprenant un élément séparateur de faisceau (40) configuré pour séparer le premier faisceau de lumière sur la base d'un rapport de séparation d'intensité lumineuse défini par *a*/*b,* avec *a* compris entre 50 et 70 et *b* compris entre 50 et 30.

5. Dispositif selon l'une quelconque des revendications 1 à 4, dans lequel ladite au moins une première source lumineuse est une lampe à cathode creuse, ledit dispositif comprenant une deuxième source lumineuse (60) configurée pour émettre un deuxième faisceau de lumière spectralement stable et ayant une longueur d'onde différente de ladite longueur d'onde d'absorption, ledit deuxième faisceau étant émis vers le capteur de lumière monodimensionnel en empruntant un chemin optique emprunté par le faisceau atténué.

6. Dispositif selon l'une quelconque des revendications 1 à 5, dans lequel les faisceaux atténué et non-atténué reçus par le capteur de lumière monodimensionnel se présentent sous la forme d'un signal spectral combiné (CS) représentatif d'une combinaison d'un signal spectral de mesure (MS) correspondant au faisceau atténué reçu et d'un signal spectral de référence (RS) correspondant au faisceau non-atténué reçu.

7. Dispositif selon l'une quelconque des revendications 1 à 6, comprenant un moyen optiquement réfléchissant (80) configuré pour réfléchir le faisceau atténué vers ledit flux de matière pour produire un faisceau doublement atténué résultant d'une transmission double du premier faisceau de lumière à travers ledit flux de matière, et dans lequel le capteur de lumière monodimensionnel est configuré pour recevoir et diriger ledit faisceau doublement atténué vers la deuxième partie du capteur de lumière monodimensionnel.

8. Procédé de mesure d'un flux de matière au moyen d'un dispositif de mesure selon l'une quelconque des revendications 1 à 7, **caractérisé en ce qu'**il comprend une étape de mesure du flux de matière en fonction du faisceau atténué reçu par la première partie du capteur de lumière monodimensionnel et du faisceau non-atténué reçu par la deuxième partie du capteur de lumière monodimensionnel.

## Patentansprüche

1. Vorrichtung zur Messung (100) eines Materialflusses, die Folgendes umfasst:
- mindestens eine erste Lichtquelle (10), die dazu eingerichtet ist, einen ersten Lichtstrahl mit einer Wellenlänge, die der Absorptionswellenlänge eines Elements von Interesse des Materialflusses entspricht, zu emittieren;
- einen optischen Verbinder (30);
- einen Lichtsensor (20), der dazu eingerichtet ist, über den optischen Verbinder Folgendes zu empfangen:
- einen abgeschwächten Strahl, der sich aus einer Übertragung des ersten Lichtstrahls durch den Materialfluss ergibt;
- einen nicht abgeschwächten Strahl, der sich aus einer Übertragung des ersten Lichtstrahls ergibt, ohne dass dieser den Materialfluss durchquert; und
wobei die Vorrichtung **dadurch gekennzeichnet ist, dass** der Lichtsensor ein eindimensionaler Lichtsensor ist;
und dass der optische Verbinder in Bezug auf den eindimensionalen Lichtsensor so positioniert ist, dass der Mittelpunkt des optischen Verbinders so auf den Mittelpunkt des eindimensionalen Lichtsensors ausgerichtet ist, dass der nicht abgeschwächte Lichtstrahl spektral zu einem ersten Teil des eindimensionalen Lichtsensors geleitet wird und der abgeschwächte Lichtstrahl spektral zu einem zweiten Teil des eindimensionalen Lichtsensors geleitet wird.

2. Vorrichtung nach Anspruch 1, wobei der eindimensionale Lichtsensor und der optische Verbinder jeweils gemäß einer Längsachse (X) und einer Ausrichtungsachse (Y) definiert sind, sodass die Längsachse (X') des Sensors und die Ausrichtungsachse (Y) des Verbinders einen Winkel (a) bilden, der in jedem Fall größer als 0° und in jedem Fall kleiner als 180° ist.

3. Vorrichtung nach Anspruch 1, wobei der eindimensionale Lichtsensor horizontal (X') positioniert ist und wobei der erste Teil ein rechter Teil (21) des eindimensionalen Lichtsensors ist und der zweite Teil ein linker Teil (22) des eindimensionalen Lichtsensors ist.

4. Vorrichtung nach einem der Ansprüche 1 bis 3, die ein Strahlaufteilungselement (40) umfasst, das dazu eingerichtet ist, den ersten Lichtstrahl auf Basis eines Lichtstärke-Aufteilungsverhältnisses aufzuteilen, welches durch *a*/*b* definiert ist, wobei *a* zwischen 50 und 70 liegt und *b* zwischen 50 und 30 liegt.

5. Vorrichtung nach einem der Ansprüche 1 bis 4, wobei die mindestens eine erste Lichtquelle eine Hohlkathodenlampe ist, wobei die Vorrichtung eine zweite Lichtquelle (60) umfasst, die dazu eingerichtet ist, einen zweiten, spektral stabilen Lichtstrahl mit einer Wellenlänge, die sich von der Absorptionswellenlänge unterscheidet, zu emittieren, wobei der zweite Strahl zu dem eindimensionalen Lichtsensor emittiert wird und dabei einem Weg folgt, dem auch der abgeschwächte Strahl folgt.

6. Vorrichtung nach einem der Ansprüche 1 bis 5, wobei der abgeschwächte und der nicht abgeschwächte Strahl, die durch den eindimensionalen Lichtsensor empfangen werden, die Form eines kombinierten Spektralsignals (CS) aufweisen, das für eine Kombination aus einem gemessenen Spektralsignal (MS), das dem empfangenen abgeschwächten Strahl entspricht, und einem Referenzspektralsignal (RS), das dem empfangenen nicht abgeschwächten Strahl entspricht, repräsentativ ist.

7. Vorrichtung nach einem der Ansprüche 1 bis 6, die ein optisch reflektierendes Mittel (80) umfasst, das dazu eingerichtet ist, den abgeschwächten Strahl zu dem Materialfluss hin zu reflektieren, um einen doppelt abgeschwächten Strahl zu produzieren, der sich aus einer zweifachen Übertragung des ersten Lichtstrahls durch den Materialfluss ergibt, und wobei der eindimensionale Lichtsensor dazu eingerichtet ist, den zweifach abgeschwächten Strahl zu empfangen und zu dem zweiten Teil des eindimensionalen Lichtsensors zu leiten.

8. Verfahren zur Messung eines Materialflusses mit einer Messvorrichtung nach einem der Ansprüche 1 bis 7, **gekennzeichnet durch** einen Schritt des Messens des Materialflusses in Abhängigkeit von dem abgeschwächten Strahl, der durch den ersten Teil des eindimensionalen Lichtsensors empfangen wird, und von dem nicht abgeschwächten Strahl, der durch den zweiten Teil des eindimensionalen Lichtsensors empfangen wird, umfasst.

## Claims

1. Device for measuring (100) a matter flux, comprising:
- at least one first light source (10) configured to emit a first light beam having a measurement wavelength corresponding to the absorption wavelength of an element of interest of said matter flux;
- an optical connector (30);
- a light sensor (20) configured to receive, via said optical connector:
∘ an attenuated beam resulting from a transmission of the first light beam through said matter flux;
∘ a non-attenuated beam resulting from a transmission of the first light beam without passing through said matter flux; and
the device being **characterized in that** the light sensor is a one-dimensional light sensor; and **in that** the optical connector is positioned relative to the one-dimensional light sensor such that the center of the optical connector is aligned with the center of the one-dimensional light sensor, such that the non-attenuated beam is spectrally directed towards a first part of the one-dimensional light sensor and such that the attenuated beam is spectrally directed towards a second part of the one-dimensional light sensor.

2. Device according to claim 1, wherein the one-dimensional light sensor and the optical connector are defined respectively along a longitudinal axis (X) and an alignment axis (Y), so that the longitudinal axis (X') of the sensor and the alignment axis of the connector form an angle (a) strictly greater than 0° and strictly smaller than 180°.

3. Device according to claim 1, wherein the one-dimensional light sensor is positioned horizontally (X'), and wherein the first part is a right-hand part (21) of the one-dimensional light sensor and the second part is a left-hand part (22) of the one-dimensional light sensor.

4. Device according to any one of the claims 1 to 3, comprising a beam splitter element (40) configured to split the first light beam on the basis of a light intensity splitting ratio defined by *a*/*b,* with *a* ranging from 50 to 70 and *b* ranging from 50 to 30.

5. Device according to any one of the claims 1 to 4, wherein said at least one first light source is a hollow cathode lamp, said device comprising a second light source (60) configured to emit a second spectrally stable light beam and having a wavelength different from said absorption wavelength, said second beam being emitted towards the one-dimensional light sensor in taking an optical path taken by the attenuated beam.

6. Device according to any one of the claims 1 to 5, wherein the attenuated and non-attenuated beams received by the one-dimensional light sensor take the form of a combined spectral signal (CS) representative of a combination of a measurement spectral signal (MS) corresponding to the attenuated beam received and a reference spectral signal (RS) corresponding to the non-attenuated beam received.

7. Device according to any one of the claims 1 to 6, comprising an optically reflecting means (80) configured to reflect the attenuated beam towards said matter flux to produce a doubly attenuated beam resulting from a double transmission of the first light beam through said matter flux and wherein the one-dimensional light sensor is configured to receive and direct said doubly attenuated beam towards the second part of the one-dimensional light sensor.

8. Method for measuring a matter flux by means of a measuring device according to any one of the claims 1 to 7, **characterized in that** it comprises a step for measuring the matter flux as a function of the attenuated beam received by the first part of the one-dimensional light sensor and of the non-attenuated beam received by the second part of the one-dimensional light sensor.
